# EUROPEAN PATENT APPLICATION

(11) **EP 1 942 528 A1**
(43) Date of publication of application: **09.07.2008**
(21) Application number: 07000095.5
(22) Date of filing: 04.01.2007
(51) Int. Cl.: H01L 29/49, H01L 29/51

(54) **Electronic device and process for manufacturing the same**

(71) Applicant: Interuniversitair Microelektronica Centrum, 3001 Leuven (BE); Samsung Electronics Co., Ltd, Suwon-si 442-743, Gyeonggi-do (KR)
(72) Inventor: Cho, Hag-Hu, 3080 Tervuren (BE); Schram, Tom, 1330 Rixensart (BE); De Gendt, Stefan, 2110 Wijnegem (BE)
(74) Representative: Bird, William Edward

(57) **Abstract**

This invention provides a device comprising:
- an electrode comprising a metal compound selected from the group consisting of the carbides, carbonitrides, nitrides, siliconitride and oxynitrides of a metal selected from the group consisting of aluminium, ruthenium, tantalum, hafnium, titanium, molybdenum and tungsten,
- a high-k dielectric layer of a metal oxide optionally comprising silicon and/or nitrogen, said high-k dielectric layer having a k value of at least 4.0, and
- a nitrogen and/or silicon barrier layer placed between said electrode and said high-k dielectric layer,
wherein said nitrogen and/or silicon barrier layer comprises one or more metal oxides, the metal of said metal oxides being selected from the group consisting of lanthanides, aluminium or hafnium, and wherein at least one of the electrode and the high-k dielectric layer comprises silicon and/or nitrogen.

## Description

### FIELD OF INVENTION

The present invention relates to the field of electronic devices and more particularly to the field of metal insulator devices such as a transistor of which a Metal-Oxide-Semiconductor Field Effect Transistor (hereinafter abbreviated as MOS-FET) is an example and/or metal-insulator-metal capacitors and their manufacture. In particular, the invention relates to improvement in the electrical properties of the electrode and/or dielectric layer of such an electronic device.

### BACKGROUND OF THE INVENTION

In semi-conductor devices such as MOS-FETs, there is a tendency of increasing drive currents. For a gate stack module, this has been achieved by a decrease of the thickness of the SiO₂ gate dielectric in order to increase its capacitance. This decrease of thickness results in problems of current leakage via tunnelling. A possible solution to this problem is the use of high-K dielectrics, i.e. dielectrics having k values above the 3.9 k-value of SiO₂. The use of high-K dielectrics allows thicker insulating dielectric layers to be used while maintaining a high capacitance.

Nitrogen and/or silicon-containing high-K dielectrics such as e.g. HfSiO and HfSiON have attracted interest because such materials are relatively amorphous while their pure oxide counter-parts (e.g. HfO₂) are usually more crystalline, which can be detrimental for the electric properties of the dielectric material. On the other hand, metal carbides, metal carbonitrides, metal nitrides, metal siliconitrides and metal oxynitrides are promising materials for use as gate electrodes because a tuning of the relative ratios of the metal and other constituents such as the carbon and the nitrogen content allows control of effective work-function over a broad range, spanning the bandgap of silicon and thus meeting bandedge work-function requirements for future complementary metal-oxide-semiconductor (CMOS) technologies.

U.S. Patent n° 6,891,231 discloses a MOS-FET composed of a channel region (e.g. silicon substrate), an insulating layer, a barrier layer and a gate electrode (nanocrystalline silicon (Poly-Si) or metal). The insulating layer is selected from Al₂O₃, HfO₂, ZrO₂, TiO₂, LaO₂, Y₂O₃, Gd₂O₃, Ta₂O₅, and silicates and aluminates thereof and the barrier layer is a layer of a nitrogen-containing compound, i.e. aluminum oxynitride, aluminum nitride or silicon nitride, deposited over the insulating layer. The reason given for the incorporation of the barrier layer at the interface between the insulating layer and the gate electrode is to, on one hand, provide resistance to dopant or metal diffusion from the gate electrode to the insulating barrier, and on the other hand, to prevent diffusion of oxygen or moisture through the insulating layer and therefore to prevent oxidation of the silicon substrate.

A problem remaining with the use of metal carbides or metal carbonitrides-containing gate electrodes is the fact that their work-functions tend to increase upon annealing when a nitrogen and/or silicon containing high-K dielectric material is used. There is therefore a need in the art for preventing the work-function increase of metal carbide or carbonitride, especially tantalum, hafnium, titanium, molybdenum, tungsten carbide or carbonitride when annealed in direct contact with a nitrogen and/or silicon containing dielectric material. U.S. Patent n° 6,891,231 does not disclose the use of metal carbides, metal carbonitrides, metal nitrides, metal siliconitride or metal oxynitrides electrodes and is silent on the problem of work-function increase of metal carbide or metal carbonitride when annealed in direct contact with a nitrogen and/or silicon containing dielectric material.

It would be advantageous to stabilise the work-function of a tantalum or hafnium carbide or carbonitride.

A further problem remaining when a metal nitride or metal carbonitride containing electrode is used is that nitrogen can diffuse into the dielectric layer and modify its electrical properties. There is therefore also a need in the art for preventing the diffusion of nitrogen from nitrogen containing electrodes to high-k dielectric layers.

### SUMMARY OF THE INVENTION

An object of the present invention is to provide electronic devices and more particularly metal insulator devices such as Metal-Oxide-Semiconductor Field Effect Transistors (hereinafter abbreviated as MOS-FETs) and/or metal-insulator-metal capacitors and methods of their manufacture. An advantage of embodiments of the present invention is the improvement in the electrical properties of the electrode and/or dielectric layer of such an electronic device.

Another advantage of embodiments of the present invention is the use of an amorphous high-k layer in combination with an electrode (e.g. a gate electrode) including materials such as tantalum or hafnium carbide or carbonitride and that the work-function of this electrode can be tuned towards band-edge, e.g. below 4.5 eV and preferably close to 4.2 eV for n-type silicon-based semi-conductor devices and above 4.5 eV and preferably close to 5.2 eV for p-type semi-conductor devices.

Broadly speaking, the present invention is based on the unexpected finding that diffusion of nitrogen is detrimental to the electrical properties of the electrode and/or high-k dielectric layer of an electronic device but this problem can be solved by a novel appropriate construction of the device. The present invention is further based on the unexpected finding that the use of a nitrogen and/or silicon barrier layer between a high-k dielectric layer and a tantalum or hafnium carbide or carbonitride gate electrode stabilises the work-function of the gate electrode.

In particular, this invention relates in a first aspect to a device comprising:
- an electrode comprising a metal compound selected from the group consisting of the carbides, carbonitrides, nitrides, siliconitrides and oxynitrides of a metal selected from the group consisting of aluminium, ruthenium, tantalum, hafnium, titanium, molybdenum and tungsten,
- a high-k dielectric layer of a metal oxide optionally comprising silicon and/or nitrogen, said high-k dielectric layer having a k value of at least 4.0, and
- a nitrogen and/or silicon barrier layer placed between said electrode and said high-k dielectric layer,
wherein said nitrogen and/or silicon barrier layer comprises one or more metal oxides, the metal of said metal oxides being selected from the group consisting of lanthanides, aluminium and hafnium, and wherein at least one of the electrode and the high-k dielectric layer comprises silicon and/or nitrogen.

In an embodiment the device is a semiconductor device wherein the stack of said electrode, said nitrogen and/or silicon barrier and said high-k dielectric layer is part of the gate stack of e.g. a transistor. This gate stack is formed upon a semiconductor layer, e.g. a semiconducting substrate or a semiconducting layer on a substrate.

In another embodiment, the device is a capacitor wherein the stack of said electrode, said nitrogen and/or silicon barrier and said high-k dielectric layer is part of the capacitor. The capacitor is built up on a conductive layer, e.g. another electrode. Optionally, additional dielectric layers can be present between said high-k dielectric layer and said conducting layer. Optionally a nitrogen and/or silicon barrier layer may be placed between said conducting layer and said high-k dielectric layer.

The present invention also relates in a second aspect to a process for manufacturing a device (such as described in the first aspect above) including a substrate, the process comprising:
(i) depositing onto a substrate a high-k dielectric layer of a metal oxide optionally comprising silicon and/or nitrogen, said high-k dielectric layer having a k value of at least 4.0,
(ii) depositing a nitrogen and/or silicon barrier layer onto said high-k dielectric layer, said nitrogen and/or silicon barrier layer comprising one or more metal oxides, the metal of said metal oxides being selected from the group consisting of lanthanides, aluminium and hafnium, and
(iii) depositing an electrode onto the silicon and/or nitrogen barrier layer, said electrode comprising a metal compound selected from the group consisting of carbides, carbonitrides, nitrides, siliconitride and oxynitrides of a metal selected from the group consisting of aluminium, ruthenium, tantalum, hafnium, titanium, molybdenum and tungsten.
If the device is, for example a semiconductor device, then the substrate comprises a semiconductor layer upon which the high-k dielectric is formed. If the device is, for example, a capacitor then the substrate comprises an electrode upon which the high-k dielectric is formed and prior to step (i), an optional step of depositing a nitrogen and/or silicon barrier may be performed.

These and other aspects of the present invention will be apparent in more details from the embodiments described hereinafter, especially with reference to the appended drawings.

### BRIEF DESCRIPTION OF THE DRAWINGS

Figure 1 is a schematic representation of a semi-conductor device according to an embodiment of the present invention.
Figure 2 is a graph showing the work-function of the tantalum carbide metal gate electrode (Ta₂C) of an embodiment of the present invention as compared to embodiments of the prior art.
Figure 3 is a schematic representation of a stack of layers according to an embodiment of the present invention
Figure 4 is a schematic representation of a capacitor according to an embodiment of the present invention

### DETAILED DESCRIPTION OF THE INVENTION

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments. Various features may be grouped in a single embodiment, figure or description. However, is not to be interpreted as reflecting an intention that the claimed invention requires more features than are expressly recited in each claim. The claims following the detailed description are hereby expressly incorporated into this detailed description, with each claim standing on its own as a separate embodiment of this invention.

In the description provided herein, numerous specific details are set forth. However, it is understood that embodiments of the invention may be practised without these specific details. In other instances, well-known methods, structures and techniques have not been shown in detail in order not to obscure an understanding of this description.

The following terms are provided solely to aid in the understanding of the invention. In embodiments of the present application, the term "substrate" may include a semiconductor material such as silicon or other materials, such as e.g. other materials used in semiconductor processing. These materials may be comprised in a bulk material or as a layer on the same or a different material. Such a substrate may be used in manufacture of an electronic device such as a transistor, e.g. a MOSFET having a stack of layers formed on such a semiconducting layer or substrate. Accordingly, a substrate may be for example doped or undoped silicon, silicon-on-insulator substrate (SOI), III-V layers such as gallium arsenide (GaAs), gallium arsenide phosphide (GaAsP), or indium phosphide (InP), germanium (Ge), germanium-on-insulator (GeOl) or silicon germanium (SiGe), glass or quartz substrates. In other embodiments of the present invention, e.g. metal-insulator-metal capacitors, the substrate can be formed on any suitable insulating substrate of which glass or quartz substrates e.g. for RF circuits, are only two examples.

In a first aspect, the present invention relates to an electronic device.

In a first general embodiment of the first aspect, the electronic device is a semiconductor device comprising an electrode, a high-k dielectric layer and a nitrogen and/or silicon barrier layer placed between the electrode and the high-k dielectric layer. The term high-k dielectric relates to materials with a k value greater than 4, e.g. between 4 and 30. This stack of layers can be deposited onto a semiconducting substrate (e.g. a silicon or a germanium based wafer) or onto a semiconductor layer formed on a substrate. The substrate can comprise source and drain regions which can be formed by e.g. ion implantation or diffusion. In embodiments of the first general embodiment, the semiconductor device is a transistor such as e.g. a field-effect transistor.

In embodiments of the first general embodiment, the electrode may be a gate electrode. The electrode can comprise a metal compound selected from the group consisting of the carbides, carbonitrides, nitrides, siliconitrides and oxynitrides of a metal selected from the group consisting of aluminium, ruthenium, tantalum, hafnium, titanium, molybdenum and tungsten. In one embodiment the electrode comprises a metal compound selected from the group consisting of tantalum carbide, tantalum carbonitride, hafnium carbide and hafnium carbonitride. The electrode can comprise (or be topped with) a polycrystalline silicon (Poly-Si) layer in addition to the above specified metal compound.

The high-k dielectric layer comprises a metal oxide having a k-value above or equal to 4.0, i.e. above the k-value of SiO₂ which is 3.9. The said k-value of the high-k dielectric material preferably ranges from 4.0 to about 30, but values above the latter upper limit may also be envisaged. Examples of such metal oxides having a k-value above or equal to 4.0 comprise but are not limited to Al₂O₃, HfO₂, ZrO₂, TiO₂, LaO₂, Y₂O₃, Gd₂O₃, Ta₂O₅, or their silicates or their aluminates among others.

In embodiments of the first general embodiment, the high-k dielectric layer may play the role of a gate dielectric. The gate dielectric layer may comprise (e.g. be doped with) one or more reactive species capable of changing the work-function of the electrode upon annealing when in contact therewith. One reason for the presence of such a reactive species is to modify the crystallinity of the high-k dielectric layer. Such reactive species can maintain the high-k dielectric layer in an amorphous state, i.e. less tendency to crystallise. It is advantageous to achieve a homogeneous layer having homogeneous electrical properties and this is more readily achieved with amorphous dielectric materials. In embodiments of the first general embodiment of the first aspect of the present invention, the reactive species is silicon and/or nitrogen. The atomic ratio metal/silicon is preferably between 1/99 and 100/0, more preferably, it is between 30/70 and 70/30. The atomic ratio metal/nitrogen in the high-k dielectric layer can range between 97/03 and 50/50, preferably between 97/03 and 60/40. For instance, HfO₂ is a crystalline metal oxide while HfSiO with a ratio hafnium silicon of 60/40 and HfSiON have more of an amorphous character. The amorphous state of HfSiON is more stable to heat treatment than the amorphous state of HfSiO. Both HfSiON and HfSiO are observed to increase the work-function of the electrode upon annealing if in contact with this metal-containing gate. For instance, the work-function of tantalum carbide shifts from about 4.3 to the range of about 4.5 - 4.6 if the high-k dielectric is HfSiON or HfSiO with an atomic ratio hafnium silicon of 60/40, and if no nitrogen and/or silicon barrier layer is placed between the metal-containing gate and the high-k dielectric layer.

The nitrogen and/or silicon barrier is a layer effectively preventing nitrogen and/or silicon to be transported from the electrode to the high-k layer or from the high-k layer to the electrode. The nitrogen and/or silicon barrier is preferably a nitrogen-free layer. The nitrogen and/or silicon barrier may also further be a silicon-free layer. In one more preferred embodiment of the first general embodiment of the first aspect of the present invention, the nitrogen and/or silicon barrier is a nitrogen barrier layer such as, but not limited to, a nitride-free barrier layer. The nitrogen and/or silicon barrier layer can comprise one or more metal oxides wherein the metal of said metal oxides is preferably selected from the group consisting of lanthanides (e.g. lanthanum), aluminium and hafnium.

In embodiments of the first general embodiment of the first aspect of the present invention, the metal of the metal oxides comprised within the nitrogen and/or silicon barrier layer may be lanthanum or a lanthanide. In other embodiments of the first general embodiment, the metal of the metal oxides comprised within the nitrogen and/or silicon barrier layer is aluminium and in yet other embodiments, the metal of the metal oxides comprised within said nitrogen and/or silicon barrier layer is hafnium.

In embodiments of the first general embodiment of the first aspect of the present invention, the metal oxide comprised within said nitrogen and/or silicon barrier layer is amorphous. An amorphous material has little long range order at an atomic scale. Differing from amorphous materials, crystalline materials have an X-ray diffraction pattern indicative of such a long range order, e.g. in the form of peaks or bands relating to crystalline configurations. Amorphous materials are characterised by the absence of such markers of crystallinity.

The thickness of the nitrogen and/or silicon barrier layer is not a critical parameter of the present invention and may be suitably selected by the skilled person based on the intended use and function of the semiconductor device. This thickness preferably is between about 0.2 nm and about 100 nm. In embodiments of the first general embodiment of the first aspect of the present invention, the thickness of the nitrogen and/or silicon barrier layer is above about 1.5 nm and below about 100 nm. In another embodiment of the first aspect of the present invention, the thickness of the nitrogen and/or silicon barrier layer is in a range from about 0.2 nm to 1 nm.

In a particular embodiment, the present invention relates to a semiconductor device comprising an electrode, said electrode comprising a tantalum or hafnium carbide or carbonitride, a high-k dielectric layer of a metal oxide comprising silicon and/or nitrogen (e.g. being doped with nitrogen), and a nitrogen and/or silicon barrier layer placed between said electrode and said high-k dielectric layer, wherein said nitrogen and/or silicon barrier layer comprises one or more metal oxides wherein the metal of said metal oxides is a lanthanide, aluminium or hafnium.

In a second general embodiment of the first aspect of the present invention, the device is a capacitor comprising an electrode, a high-k dielectric layer of a metal oxide comprising silicon and/or nitrogen (e.g. being doped with nitrogen), and a nitrogen and/or silicon barrier layer placed between said electrode and said high-k dielectric layer, wherein said nitrogen and/or silicon barrier layer comprises one or more metal oxides. This stack of layers can be deposited onto a conductive substrate (e.g. a metal or a metal compound as defined in the first general embodiment of the first aspect of the present invention). In some embodiments of the second general embodiment of the first aspect of the present invention, the capacitor can be part of a semiconductor integrated circuit. In some embodiments of the second general embodiment of the first aspect of the present invention, the capacitor can be combined with a semiconductor device such as e.g. a transistor.

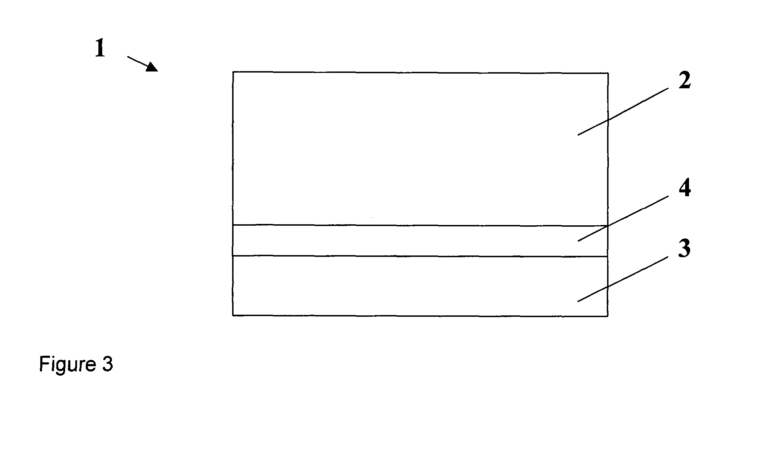

In embodiments of the second general embodiment of the first aspect of the present invention, the capacitor structure further comprises a conductive substrate, e.g. another electrode, such that the nitrogen and/or silicon barrier layer and the high-k layer is sandwiched between the electrode and the conductive substrate. The manufacturing steps used to form such capacitor structures are similar to the manufacturing steps used to fabricate a semiconductor device as disclosed in the first general embodiment. A capacitor according to embodiments of the present invention thus comprises at least a metal electrode formed on top of a nitrogen and/or silicon barrier on a high-k dielectric layer of a metal oxide comprising silicon and/or nitrogen as illustrated in figure 3. The capacitor further comprises a conductive substrate (e.g. another electrode) on which the high-k dielectric layer may be deposited and optionally additional dielectric layers in between the high-k dielectric layer and the conductive substrate.

The electrode and the conductive substrate can be the same or different. Nitrogen and/or silicon barrier layers can be the same or different. The conductive layer can be a metal. The electrode and the conductive layer can comprise independently from one another a metal compound selected from the group consisting of the carbides, carbonitrides, nitrides, siliconitrides and oxynitrides of a metal selected from the group consisting of aluminium, ruthenium, tantalum, hafnium, titanium, molybdenum and tungsten. In examples of the second general embodiment, the electrode and the conductive layer comprise, independently from one another, a metal compound selected from the group consisting of tantalum carbide, tantalum carbonitride, hafnium carbide and hafnium carbonitride. The electrode can comprise (or be topped with) a polycrystalline silicon (Poly-Si) layer in addition to the above specified metal compound.

The high-k dielectric layer comprises a metal oxide having a k-value above or equal to 4.0, i.e. above the k-value of SiO₂ which is 3.9. The said k-value of the high-k dielectric material preferably ranges from 4.0 to about 30, but values above the latter upper limit may also be envisaged. Examples of such metal oxides having a k-value above or equal to 4.0 comprise but are not limited to Al₂O₃, HfO₂, ZrO₂, TiO₂, LaO₂, Y₂O₃, Gd₂O₃, Ta₂O₅, their silicates and their aluminates among others.

The high-k dielectric layer can comprise (e.g. be doped with) one or more reactive species capable of changing the work-function of the electrode (2) upon annealing when in contact therewith. One reason for the presence of such a reactive species is to modify the crystallinity of the high-k dielectric layer. Such reactive species can maintain the high-k dielectric layer amorphous, i.e. less tendency to crystallise. It is advantageous to achieve a homogeneous layer having homogeneous electrical properties and this is more readily achieved with amorphous dielectric materials. In embodiments of the second general embodiment of the first aspect of the present invention, the reactive species is silicon and/or nitrogen. The atomic ratio metal/silicon is between 1/99 and 100/0, preferably, it is between 30/70 and 70/30. The atomic ratio metal/nitrogen in the high-k dielectric layer can range between 97/03 and 50/50, preferably between 97/03 and 60/40. For instance, HfO₂ is a crystalline metal oxide while HfSiO with a ratio hafnium silicon of 60/40 and HfSiON have a higher amorphous character. The amorphous state of HfSiON is more stable to heat treatment than the amorphous state of HfSiO. Both HfSiON and HfSiO are observed to increase the work-function of the electrode upon annealing if in contact with this metal-containing gate. For instance, the work-function of tantalum carbide shifts from about 4.3 to the range of about 4.5 - 4.6 if the high-k dielectric is HfSiON or HfSiO, and if no nitrogen and/or silicon barrier layer is placed between the metal-containing gate and the high-k dielectric layer.

The nitrogen and/or silicon barriers are layers effectively preventing nitrogen and/or silicon to be transported from the electrode/conductive layers to the high-k layer or from the high-k layer to the electrode/conductive layers. The nitrogen and/or silicon barriers are preferably nitrogen-free layers. The nitrogen and/or silicon barriers may also further be silicon-free layers. In one more preferred embodiment of the present invention, the nitrogen and/or silicon barrier is a nitrogen barrier layer such as, but not limited to, a nitrogen and/or silicon barrier layer. The nitrogen and/or silicon barrier layer comprises one or more metal oxides wherein the metal of said metal oxides is preferably selected from the group consisting of lanthanides (e.g. lanthanum), aluminium and hafnium.

In embodiments of the second general embodiment of the first aspect of the present invention, the metal of the metal oxides comprised within the nitrogen and/or silicon barrier layer is lanthanum or a lanthanide. In other embodiments, the metal of the metal oxides comprised within the nitrogen and/or silicon barrier layer is aluminium and in yet other embodiments the metal of the metal oxides comprised within said nitrogen and/or silicon barrier layer is hafnium.

In embodiments of the second general embodiment of the first aspect of the present invention, the metal oxide comprised within said nitrogen and/or silicon barrier layer is amorphous. The thickness of the nitrogen and/or silicon barrier layer is not a critical parameter of the present invention and may be suitably selected by the skilled person based on the intended use and function of the semiconductor device. This thickness preferably is between about 0.2 nm and about 100 nm. In embodiments, the thickness of the nitrogen and/or silicon barrier layer is above about 1.5 nm and below about 100 nm. In another embodiment of the first aspect of the present invention, the thickness of the nitrogen and/or silicon barrier layer is in a range from about 0.2 nm to 1 nm.

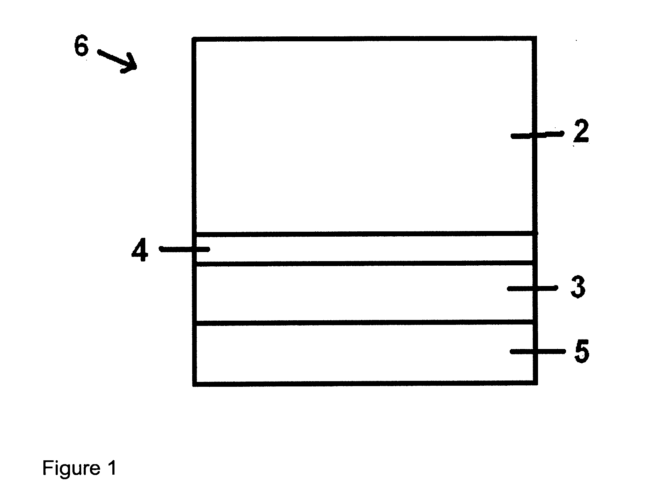

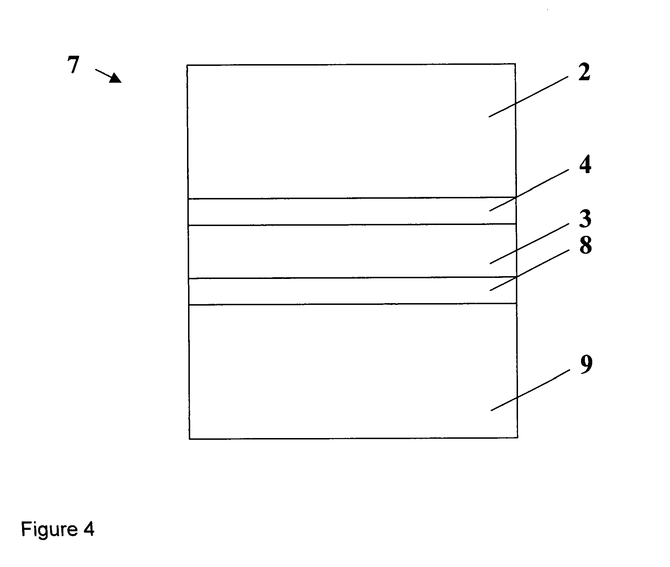

Figure 3 schematically shows a device (1) according to embodiments of the first aspect of the present invention. The device (1) comprises a stack of layers comprising (a) a high-k dielectric layer (3) of a metal oxide comprising silicon and/or nitrogen, (b) a nitrogen and/or silicon barrier (4) provided on top of this high-k dielectric layer (3), and (c) a gate electrode (2) topping the stack of layers (3, 4). The stack of layers (2, 3, 4) as shown in figure 3 can be used as a gate stack of a semiconductor device, as illustrated by figure 1 or it can be used as a stack of layers in a capacitor as exemplified in Figure 4.

Figure 1 schematically shows a semiconductor device (6) according to an embodiment of the present invention. The bottom layer is a semiconducting substrate (5) on which a high-k dielectric layer (3) of a metal oxide comprising silicon and/or nitrogen is present. On top of this high-k dielectric layer (3), a nitrogen and/or silicon barrier (4) is provided and this whole stack of layers (5, 3, 4) is topped by a gate electrode (2).

Figure 4 schematically shows a capacitor (7) according to the second general embodiment of the first aspect of the present invention. In Figure 4, the high-k layer (3) is separated from the electrode (2) and the conductive layer (9) by nitrogen and/or silicon barrier layers (4) and (8).

In a second aspect, the present invention relates to a three-step process for manufacturing a device (1):
(i) depositing onto a substrate a high-k dielectric layer of a metal oxide optionally comprising silicon and/or nitrogen, said high-k dielectric layer having a k value of at least 4.0,
(ii) depositing a nitrogen and/or silicon barrier layer onto said high-k dielectric layer, said nitrogen and/or silicon barrier layer comprising one or more metal oxides, the metal of said metal oxides being selected from the group consisting of lanthanides, aluminium and hafnium, and
(iii) depositing an electrode onto the silicon and/or nitrogen barrier layer, said electrode comprising a metal compound selected from the group consisting carbides, carbonitrides, nitrides, siliconitrides and oxynitrides of a metal selected from the group consisting of aluminium, ruthenium, tantalum, hafnium, titanium, molybdenum and tungsten.
The process of the invention further optionally comprises a step (iv) of depositing a Poly-Si layer onto the electrode comprising the specified metal compound.

All steps (i) to (iii) of the process according to the present invention may be performed at room temperature or at higher temperature, and one or more degassing steps at a higher temperature can be performed before any of such steps in accordance with standard practice in the semiconductor device manufacturing industry. Degassing can for instance be performed at temperatures ranging from about 300°C to about 400°C, such as e.g. about 350°C.

Before the performance of step (i), a pre-cleaning or a surface pretreatment of the substrate can be performed in any appropriate way well known to the person skilled in the art. Steps (i) to (iii) can each independently be performed via a variety of techniques well known by the person skilled in the art. For instance, a chemical vapour deposition technique (herein-after abbreviated as CVD) such as, but not limited to, e.g. atomic layer CVD, or a physical vapour deposition (herein-after abbreviated as PVD) technique such as, but not limited to, sputtering can be suitably used at each of three main process steps (i) to (iii), and the optional process step (iv).

After step (iii or iv), annealing of the device can be performed in accordance with standard practice in the art. Examples of suitable annealing conditions include, but are not limited to, an annealing time of about 1-120 seconds at an annealing temperature between about 600 and about 900 °C, preferably about 30 - 120 seconds at an annealing temperature between about 600 and 700°C, or an annealing time of about 0.5 - 2 seconds at an annealing temperature between about 900 and about 1200°C, e.g. under an atmosphere of helium. An annealing treatment can be performed after any other steps as well, such as e.g. an annealing time of about 1-120 seconds at an annealing temperature between 600 and 900 °C after step (i).

The following examples are presented for illustrative purpose only and shall not be construed as limiting the scope or the number of embodiments of the present invention.

### Example 1

A silicon wafer was coated with 2.5 nm of HfSiO by atomic layer CVD with an atomic ratio hafnium/silicon of 60/40. A HfSiON layer was then obtained by subjecting HfSiO to a plasma nitridation. A 1 nm layer of HfO₂ was then deposited on top of the HfSiON layer. The assembly obtained was degassed for 4 minutes at 350°C and a 10 nm layer of Ta₂C was deposited on top of the assembly by means of physical vapour deposition. The resulting assembly was then capped with an additional Poly-Si layer and annealed at about 1030°C for 1 second. The work-function of the device obtained was measured as 4.45 eV.

### Comparative example 1

A silicon wafer was coated with 2.5 nm of a HfSiO layer by means of an atomic layer CVD technique with an atomic ratio hafnium/silicon of 60/40. A HfSiON layer was then obtained by subjecting HfSiO to a plasma nitridation. No HfO₂ were then deposited on top of the HfSiON layer. The obtained assembly was degassed 4 minutes at 350 °C and a 10 nm layer of Ta₂C was deposited on top of it by physical vapour deposition. The resulting assembly was then capped with a Poly-Si layer and annealed at about 1030°C under He atmosphere for 1 second. The work-function of the gate electrode was measured as 4.53 eV.

### Comparative example 2

A silicon wafer was coated with 2.5 nm of a HfO₂ layer by means of an atomic layer CVD technique. The obtained assembly was degassed 4 minutes at 350 °C and a 10 nm layer of Ta₂C was deposited on top of it by means of a physical vapour deposition technique. The resulting assembly was then capped with Poly-Si and annealed at about 1030°C under He atmosphere for 1 second. The work-function of the obtained device was 4.39 eV.

### Comparative example 3

A silicon wafer was coated with 2.5 nm of a SiO₂ layer by atomic layer CVD. The obtained assembly was degassed for 4 minutes at 350°C and a 10 nm layer of Ta₂C was deposited on top of it by means of a physical vapour deposition technique. The resulting assembly was then capped with a Poly-Si layer and annealed at about 1030°C under He atmosphere for 1 second. The work-function of the obtained device was 4.33 eV.

### Comparative example 4

A silicon wafer was coated with 2.5 nm of a SiO₂ layer by means of atomic layer CVD technique. A SiON layer was then obtained by subjecting said SiO₂ layer to a plasma nitridation. The obtained assembly was then degassed for 4 minutes at 350°C and a 10 nm layer of Ta₂C was deposited on top of it by physical vapour deposition. The resulting assembly was then capped with a Poly-Si layer and annealed at about 1030°C under a helium atmosphere for 1 second. The work-function of the gate electrode was measured as 4.35 eV.

### Comparative example 5

A silicon wafer was coated with 2.5 nm of a HfSiO layer by means of an atomic layer CVD technique with an atomic ratio hafnium/silicon of 60/40. No HfO₂ layer was deposited on top of the HfSiO layer. The obtained assembly was degassed 4 minutes at 350°C and a 10 nm layer of Ta₂C was deposited on top of it by physical vapour deposition. The resulting assembly was then capped with a Poly-Si layer and annealed at about 1030°C under a He atmosphere for 1 second. The work-function of the gate electrode was 4.60 eV.

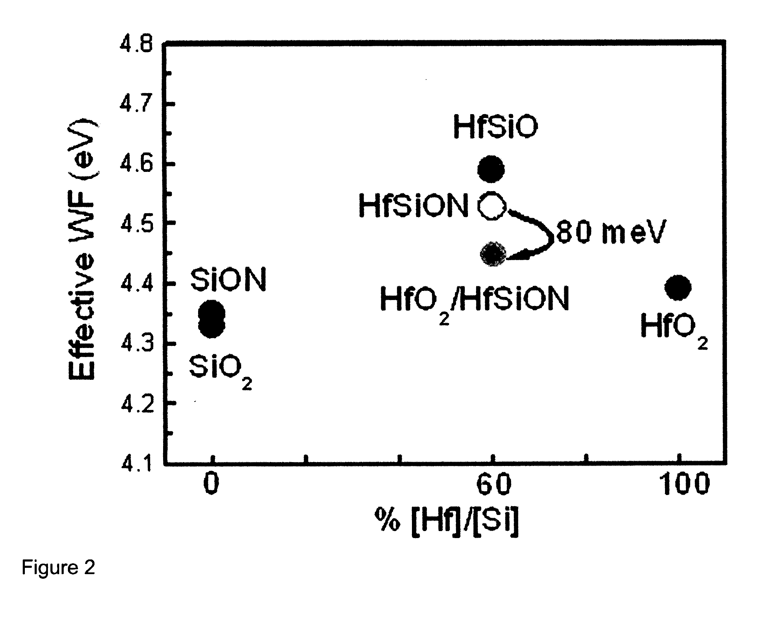

As a summary, the work-function of the metal gate electrode of Example 1 (Ta₂C), and of comparative examples 1 to 5, is shown on Figure 2. The X-axis of Figure 2 provides the relative hafnium and silicon atomic content of the high-k dielectric layer of the device under investigation. The Y-axis provides the work-function in eV. At 0% hafnium, the work-function of the gate electrode in comparative example 3 (dielectric layer= SiO₂) and comparative example 4 (dielectric layer = SiON) were 4.33 and 4.35 eV respectively. At a 60% hafnium/silicon atomic content, the work-function of the gate electrode in comparative example 1 (high-k dielectric layer = HfSiON) and comparative example 5 (high-k dielectric layer = HfSiO) were 4.53 eV and 4.60 eV respectively. The use of a nitrogen and/or silicon barrier layer between the substrate and the HfSiON high-k gate dielectric layer provided a work-function of 4.45 eV. When the gate dielectric contains no silicon and consists of crystalline HfO₂ (comparative example 2), the work-function is 4.39 eV. The work-function of the gate electrode in example 1 is 80 meV lower than in comparative example 1 where no nitrogen and/or silicon barrier was used.

### Example 2

A silicon wafer was coated with 2.5 nm of a HfSiO layer by means of atomic layer CVD with an atomic ratio hafnium/silicon of 60/40. A HfSiON layer was then obtained by subjecting said HfSiO layer to a plasma nitridation. 1 nm of a HfO₂ layer was then deposited on top of the HfSiON layer. The obtained assembly was degassed for 4 minutes at 350°C and a 10 nm layer of TaC was deposited on top of it by means of physical vapour deposition. The resulting assembly was then capped with a Poly-Si layer and annealed at about 1050°C under He atmosphere for 1.5 second.

### Example 3

A silicon wafer was coated with 2.5 nm of a HfSiO layer by means of atomic layer CVD with an atomic ratio hafnium/silicon of 60/40. A HfSiON layer was then obtained by subjecting said HfSiO layer to plasma nitridation. A 2 nm layer of HfO₂ was then deposited on top of the HfSiON layer. The obtained assembly was degassed for 4 minutes at 350°C and a 10 nm layer of TaC was deposited on top of it by means of physical vapour deposition. The resulting assembly was then capped with a Poly-Si layer and annealed at about 1050°C under He atmosphere for 1.5 second.

### Example 4

A silicon wafer was coated with 2.5 nm of HfSiO by means of atomic layer CVD with an atomic ratio hafnium/silicon of 60/40. HfSiON was then obtained by subjecting HfSiO to a plasma nitridation. 1 nm of HfO₂ were then deposited on top of the HfSiON layer. The obtained assembly was degassed 4 minutes at 350°C and a 10 nm layer of Ta₂C was deposited on top of it by means of physical vapour deposition. The resulting assembly was then capped with Poly-Si and annealed at about 1050 °C under He atmosphere for 1.5 second.

### Example 5

A silicon wafer was coated with 2.5 nm of a HfSiO layer by means of atomic layer CVD with an atomic ratio hafnium/silicon of 60/40. HfSiON was then obtained by subjecting said HfSiO layer to a plasma nitridation. A 2 nm HfO₂ layer was then deposited on top of the HfSiON layer. The obtained assembly was degassed 4 minutes at 350°C and a 10 nm layer of Ta₂C was deposited on top of it by physical vapour deposition. The resulting assembly was then capped with a Poly-Si layer and annealed at about 1050°C under He atmosphere for 1.5 second.

### Example 6

A silicon wafer is coated with 2.5 nm of a HfSiO layer by means of atomic layer CVD with an atomic ratio hafnium/silicon of 60/40. A HfSiON layer is then obtained by subjecting said HfSiO layer to a plasma nitridation. A 1 nm layer of HfO₂ is then deposited on top of the HfSiON layer. The obtained assembly is degassed 4 minutes at 350 °C and a 10 nm layer of TaCN is deposited on top of it by means of physical vapour deposition. The resulting assembly is then capped with a Poly-Si layer and annealed at about 1050 °C under He atmosphere for 1.5 second.

### Example 7

A silicon wafer is coated with 2.5 nm of a HfSiO layer by means of atomic layer CVD with an atomic ratio hafnium/silicon of 60/40. A HfSiON layer is then obtained by subjecting said HfSiO layer to a plasma nitridation. 1 nm of a HfO₂ layer is then deposited on top of the HfSiON layer. The obtained assembly is degassed 4 minutes at 350°C and a 10 nm layer of a HfC layer is deposited on top of it by means of physical vapour deposition. The resulting assembly is then capped with a Poly-Si layer and annealed at about 1050 °C under He atmosphere for 1.5 second.

### Example 8

A silicon wafer is coated with 2.5 nm of a HfSiO layer by means of atomic layer CVD with an atomic ratio hafnium/silicon of 60/40. A HfSiON layer is then obtained by subjecting said HfSiO layer to a plasma nitridation. 1 nm layer of HfO₂ are then deposited on top of the HfSiON layer. The obtained assembly is degassed 4 minutes at 350 °C and a 10 nm layer of HfCN is deposited on top of it by means of physical vapour deposition. The resulting assembly is then capped with a Poly-Si layer and annealed at about 1050°C under He atmosphere for 1.5 second.

### Example 9

A silicon wafer was coated with 2.5 nm of a HfSiO layer by means of atomic layer CVD with an atomic ratio hafnium/silicon of 60/40. A HfSiON layer was then obtained by subjecting said HfSiO layer to a plasma nitridation. 1 nm of a HfO₂ layer was then deposited on top of the HfSiON layer. The obtained assembly was degassed for 4 minutes at 350°C and a 10 nm layer of Ta₂C was deposited on top of it by means of physical vapour deposition. The resulting assembly was then capped with a Poly-Si layer and annealed at about 650°C for 1 minute.

### Example 10

A silicon wafer was coated with 2.5 nm of a HfSiO layer by means of atomic layer CVD with an atomic ratio hafnium/silicon of 60/40. A HfSiON layer was then obtained by subjecting HfSiO to a post nitridation annealing step. 1 nm of HfO₂ were then deposited on top of the HfSiON layer. The obtained assembly was degassed 4 minutes at 350 °C and a 10 nm layer of Ta₂C was deposited on top of it by means of physical vapour deposition. The resulting assembly was then capped with a Poly-Si layer and annealed at about 650°C for 1 minute.

## Claims

1. A device (1, 6, 7) comprising:
- an electrode (2) comprising a metal compound selected from the group consisting of the carbides, carbonitrides, nitrides, siliconitrides and oxynitrides of a metal selected from the group consisting of aluminium, ruthenium, tantalum, hafnium, titanium, molybdenum and tungsten,
- a high-k dielectric layer (3) of a metal oxide optionally comprising silicon and/or nitrogen, said high-k dielectric layer (3) having a k value of at least 4.0, and
- a nitrogen and/or silicon barrier layer (4) placed between said electrode (2) and said high-k dielectric layer (3),
wherein said nitrogen and/or silicon barrier layer (3) comprises one or more metal oxides, the metal of said metal oxides being selected from the group consisting of lanthanides, aluminium or hafnium, and wherein at least one of the electrode (2) and the high-k dielectric layer (3) comprises silicon and/or nitrogen.

2. A device (1, 6, 7) according to claim 1 further comprising a substrate (5, 9) onto which said high-k dielectric layer (3) is placed.

3. A device (1, 6, 7) according to claim 2, wherein said substrate (5, 9) is a semiconductive substrate (5) or conductive substrate (9).

4. A device (1, 6, 7) according to any of claims 1 to 3, wherein said high-k dielectric layer (3) comprises nitrogen.

5. A device (1, 6, 7) according to any of claims 1 to 4, wherein said electrode (2) comprises a metal compound selected from the group consisting of tantalum carbide, tantalum carbonitride, hafnium carbide and hafnium carbonitride.

6. A device (1, 6, 7) according to any of claims 1 to 5, wherein the thickness of said nitrogen and/or silicon barrier layer (4) is above 1.5 nm and below 100 nm.

7. A device (1, 6, 7) according to any of claims 1 to 5, wherein the thickness of said nitrogen and/or silicon barrier layer (4) is in a range from 0.2 nm to 1 nm.

8. A device (1, 6, 7) according to any of claims 1 to 7, wherein the metal of said metal oxides comprised within said nitrogen and/or silicon barrier layer (4) is lanthanum or a lanthanide.

9. A device (1, 6, 7) according to any of claims 1 to 7, wherein the metal of said metal oxides comprised within said nitrogen and/or silicon barrier layer (4) is hafnium.

10. A device (1, 6, 7) according to any of claims 1 to 9, wherein said metal oxide comprised within said nitrogen and/or silicon barrier layer (4) is amorphous.

11. A device (1, 6, 7) according to any of claims 1 to 10, wherein said electrode consists of tantalum carbide.

12. A device according to any of the claims 1 to 11, wherein the device is part of a capacitor.

13. A device according to any of the claims 1 to 11, wherein the device is part of a gate of a transistor.

14. A device according to claim 13, wherein the transistor is a MOS-FET.

15. A process for the manufacturing of a device (1, 6, 7) on a substrate comprising the steps of:
(i) depositing onto said substrate (5, 9) a high-k dielectric layer of a metal oxide optionally comprising silicon and/or nitrogen, said high-k dielectric layer (3) having a k-value of at least 4.0,
(ii) depositing a nitrogen and/or silicon barrier layer (4) onto said high-k dielectric layer (3), wherein said nitrogen and/or silicon barrier layer comprises one or more metal oxides, the metal of said metal oxides being selected from the group consisting of a lanthanide, aluminium and hafnium, and
(iii) depositing an electrode (2) onto the nitrogen and/or silicon barrier layer (4), wherein said electrode (2) comprises a metal compound selected from the group consisting of the carbides, carbonitrides, nitrides, siliconitride and oxynitrides of a metal selected from the group consisting of aluminium, ruthenium, tantalum, hafnium, titanium, molybdenum and tungsten.

16. A process according to claim 15, further comprising the step (iv) of depositing a Poly-Si layer onto said electrode (2).
